# EUROPEAN PATENT APPLICATION

(11) **EP 4 742 857 A2**
(43) Date of publication of application: **13.05.2026**
(21) Application number: 25210385.8
(22) Date of filing: 22.10.2025
(51) Int. Cl.: H10D 84/01, H10D 84/83, H10D 84/85, H10D 88/00, H10D 30/00, H10D 84/03, H10D 64/27, H10D 30/01

(54) **INTEGRATED CIRCUIT DEVICES INCLUDING STACKED TRANSISTORS WITH MATCHED WORK FUNCTION SCHEME AND METHODS OF FABRICATION THE SAME**

(30) Priority: 06.11.2024 US 202463716879 P; 30.04.2025 US 202519194957
(71) Applicant: Samsung Electronics Co., Ltd., Suwon-si, Gyeonggi-do 16677 (KR)
(72) Inventor: PARK, Junmo, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Integrated circuit devices and methods of forming the same are provided. The integrated circuit devices may include a first transistor on a substrate; and a second transistor on the first transistor, wherein the first transistor is between the substrate and the second transistor in a vertical direction that is perpendicular to an upper surface of the substrate, wherein the first transistor comprises: first channel layers that are spaced apart from each other in the vertical direction; and a first work function layer on the first channel layers, wherein the second transistor comprises: second channel layers that are spaced apart from each other in the vertical direction; and a second work function layer on the second channel layers, and wherein the second work function layer is spaced apart from the first channel layers.

## Description

### BACKGROUND

The present disclosure generally relates to the field of integrated circuit devices and, more particularly, to integrated circuit devices including stacked transistors.

Various structures of an integrated circuit device and methods of forming the same have been proposed to increase the integration density. For example, a stacked transistor structure including multiple transistors vertically stacked has been proposed.

### SUMMARY

An aspect of the present disclosure is to provide integrated circuit devices with improved electrical characteristics and reliability characteristics, and methods for manufacturing the same. More specifically, an aspect of the present disclosure is to provide integrated circuit devices, including a stacked transistor structure comprising multiple transistors and matched work function layers therefor to improve and optimize the performance. However, it will be understood that the embodiments, goals, and benefits of the present disclosure are not limited to the descriptions above.

An integrated circuit device, according to some embodiments, may include a first transistor on a substrate; and a second transistor on the first transistor, wherein the first transistor is between the substrate and the second transistor in a vertical direction that is perpendicular to an upper surface of the substrate, wherein the first transistor comprises: first channel layers that are spaced apart from each other in the vertical direction; and a first work function layer on the first channel layers, wherein the second transistor comprises: second channel layers that are spaced apart from each other in the vertical direction; and a second work function layer on the second channel layers, and wherein the second work function layer is spaced apart from the first channel layers.

An integrated circuit device, according to some embodiments, may include a first transistor on a substrate; a second transistor on the first transistor; and an insulator between the first transistor and the second transistor in a vertical direction that is perpendicular to an upper surface of the substrate, wherein the first transistor comprises: first channel layers that are spaced apart from each other in the vertical direction; and a first work function layer on the first channel layers, wherein the second transistor comprises: second channel layers that are spaced apart from each other in the vertical direction; and a second work function layer on the second channel layers, and wherein the second work function layer is spaced apart from the first channel layers by the first work function layer.

A method of forming an integrated circuit device, according to some embodiments, may include forming a first stack that comprises first channel layers on a substrate and a second stack that comprises second channel layers on the first stack, wherein the first channel layers are spaced apart from each other in a vertical direction that is perpendicular to an upper surface of the substrate, and the second channel layers are spaced apart from each other in the vertical direction; forming an insulator between the first stack and the second stack in the vertical direction; forming a dummy layer that extends around the first channel layers, the second channel layers, and the insulator; replacing an upper portion of the dummy layer with a first inner work function layer that is on the second channel layers; replacing a lower portion of the dummy layer with a second work function layer that is on the first channel layers; and forming a first outer work function layer on the first inner work function layer, the insulator, and the second work function layer, wherein the first outer work function layer is spaced apart from the first channel layers by the second work function layer.

### BRIEF DESCRIPTION OF THE DRAWINGS

FIG. 1 is a cross-sectional view of an integrated circuit device according to some embodiments.
FIG. 2 is a flowchart of methods of forming an integrated circuit device according to some embodiments.
FIGS. 3 through 19 are cross-sectional views illustrating methods of forming an integrated circuit device according to some embodiments.

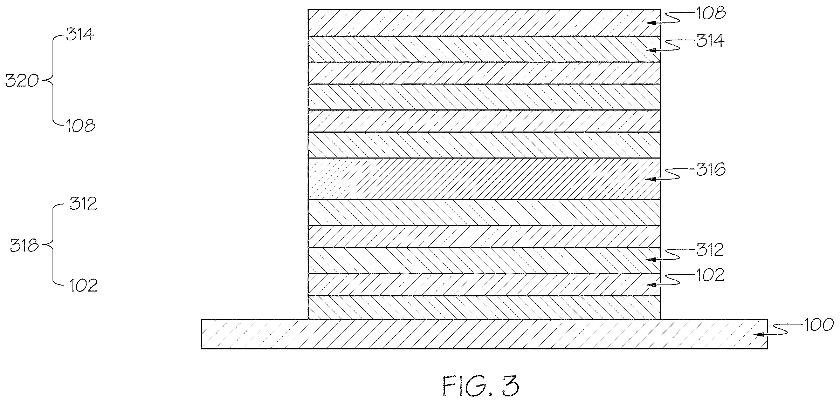

FIG. 3 is a cross-sectional view of an intermediate process, including forming an inter-gate sacrificial layer on a stack.

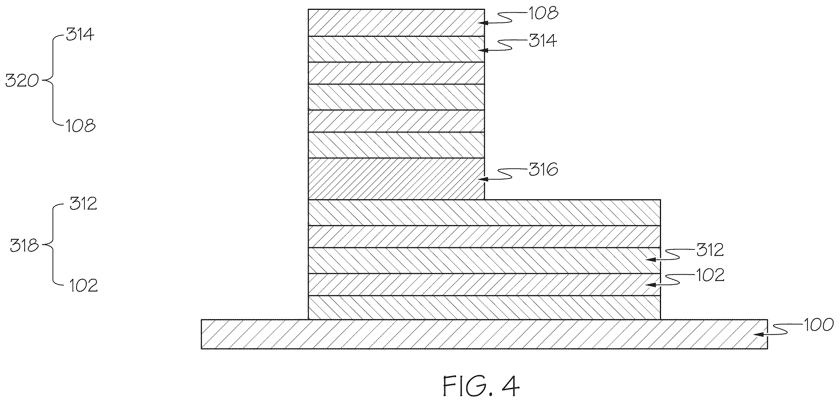

FIG. 4 is a cross-sectional view of an intermediate process, including removing a portion of the inter-gate sacrificial layer and a portion of the stack.

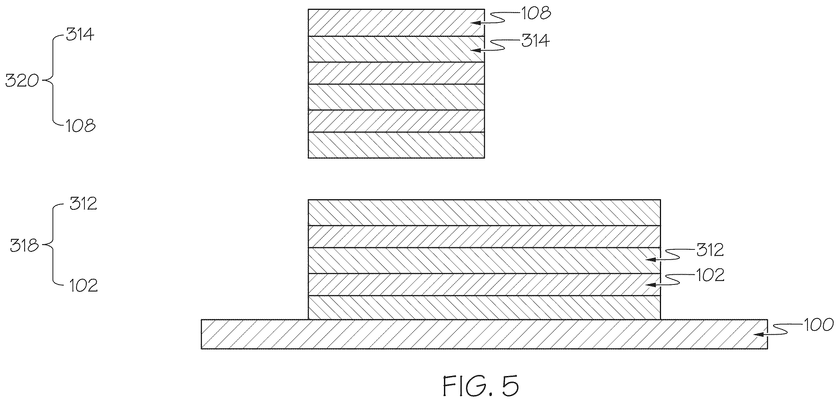

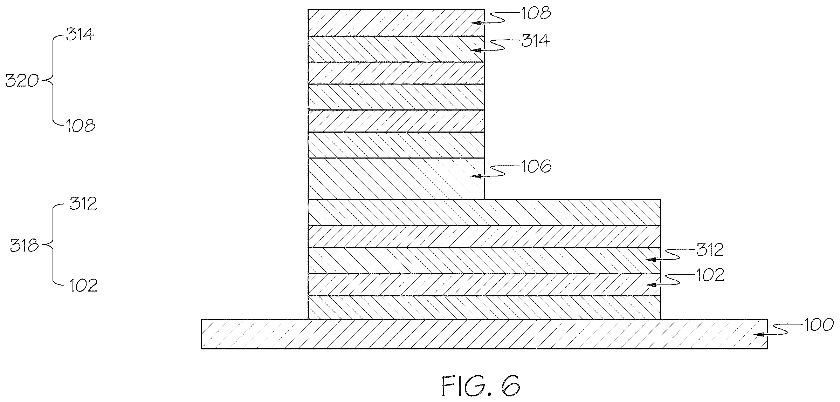

FIGS. 5 and 6 are cross-sectional views of an intermediate process, including replacing the inter-gate sacrificial layer with an insulator.

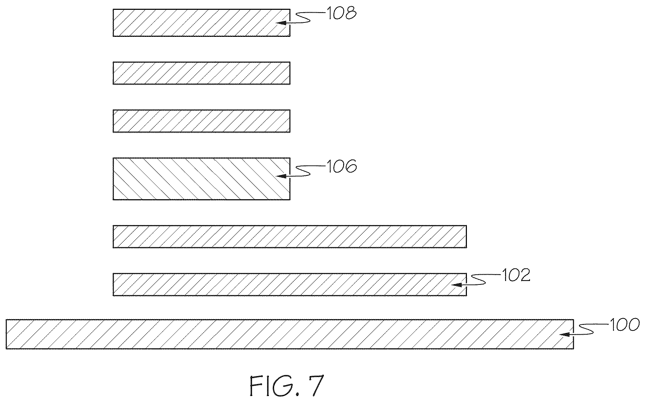

FIG. 7 is a cross-sectional view of an intermediate process, including removing sacrificial layers.

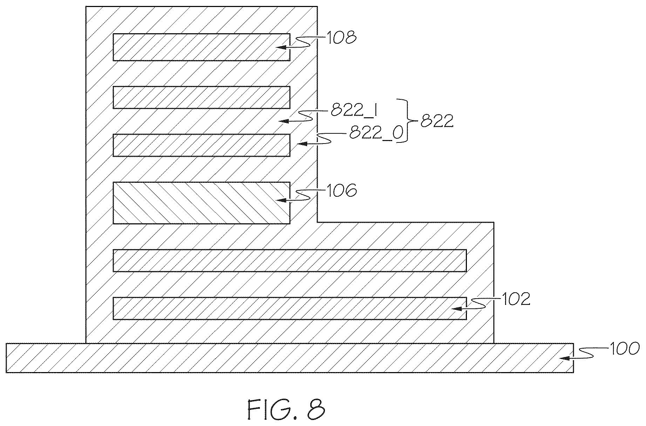

FIG. 8 is a cross-sectional view of an intermediate process, including forming a dummy layer.

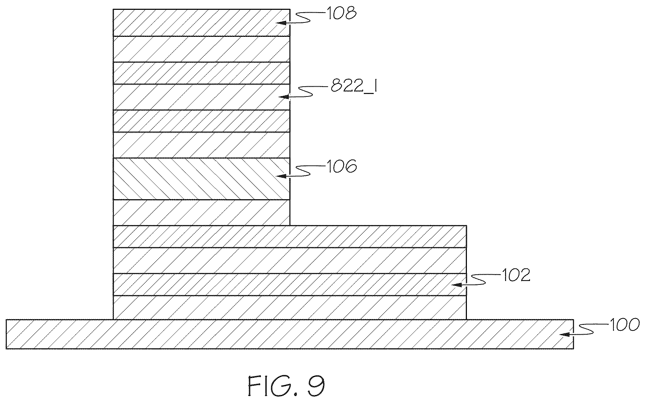

FIG. 9 is a cross-sectional view of an intermediate process, including removing an outer dummy layer.

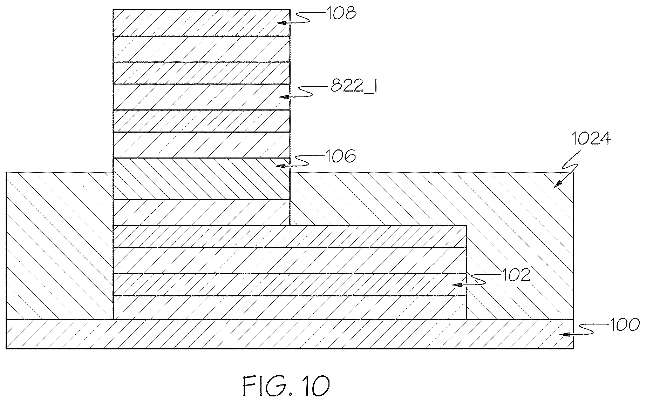

FIG. 10 is a cross-sectional view of an intermediate process, including forming a block layer.

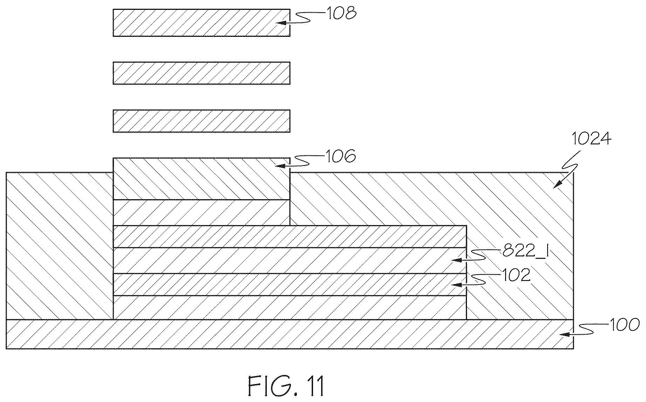

FIG. 11 is a cross-sectional view of an intermediate process, including removing upper inner dummy layers.

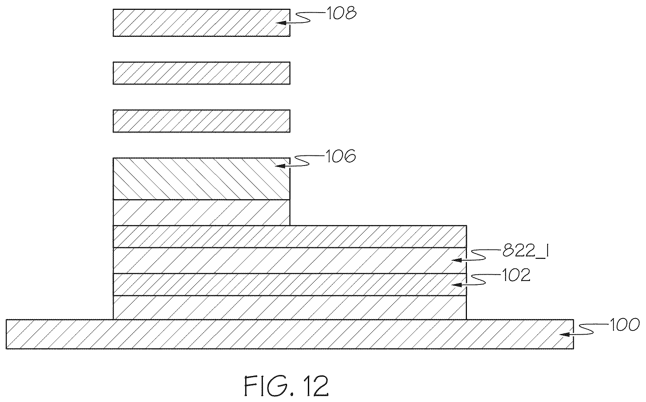

FIG. 12 is a cross-sectional view of an intermediate process, including removing the block layer.

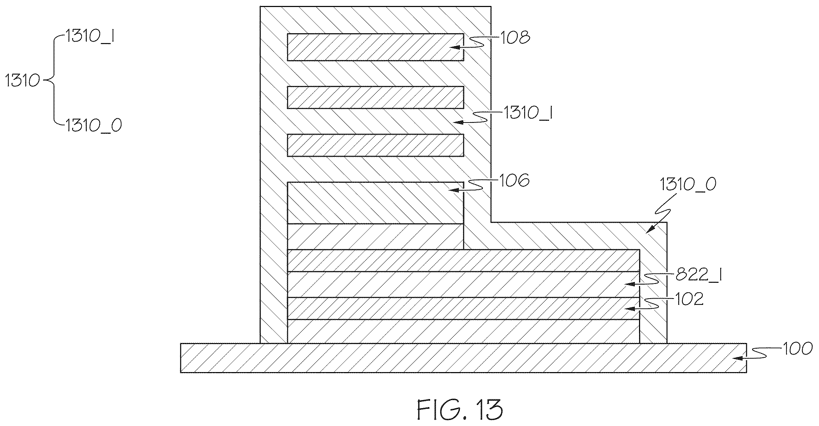

FIG. 13 is a cross-sectional view of an intermediate process, including forming a preliminary work function layer.

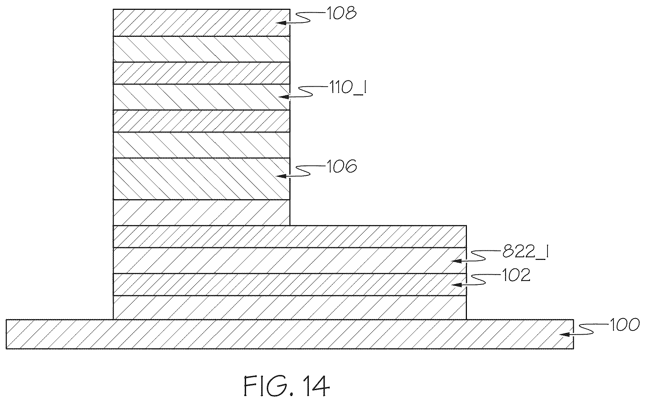

FIG. 14 is a cross-sectional view of an intermediate process, including removing an outer preliminary work function layer.

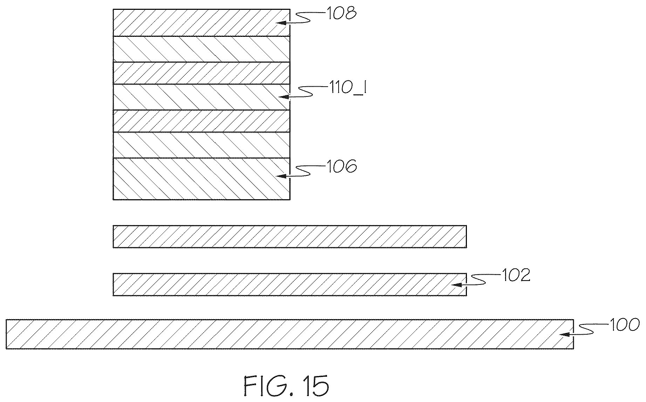

FIG. 15 is a cross-sectional view of an intermediate process, including removing lower inner dummy layers.

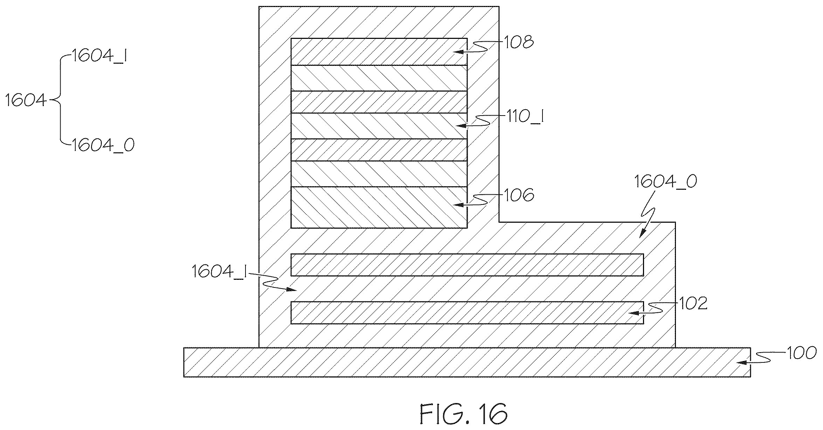

FIG. 16 is a cross-sectional view of an intermediate process, including forming a preliminary work function layer.

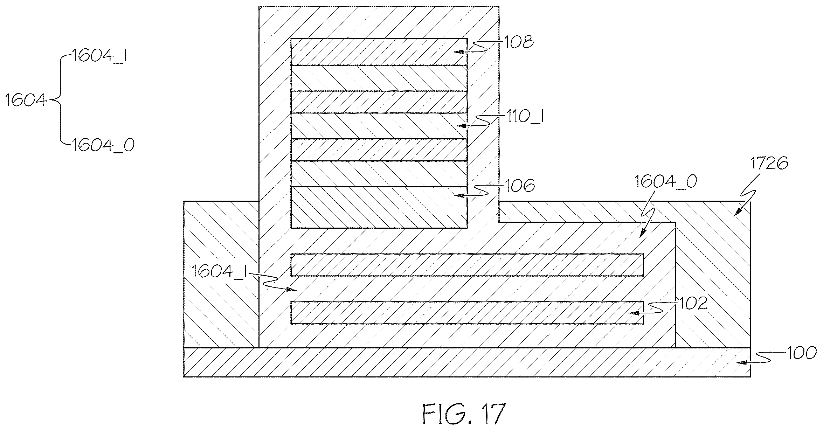

FIG. 17 is a cross-sectional view of an intermediate process, including forming a block layer.

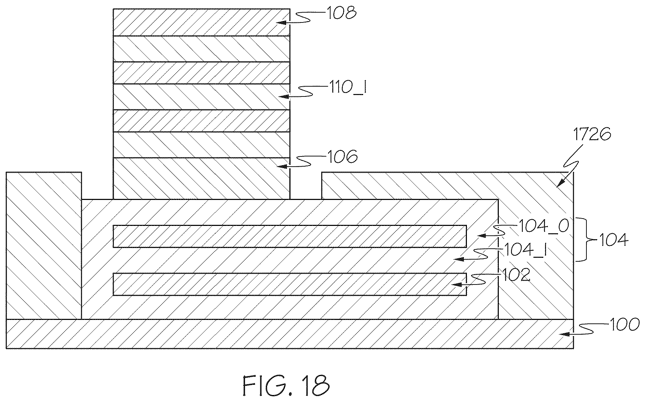

FIG. 18 is a cross-sectional view of an intermediate process, including removing a portion of the preliminary work function layer.

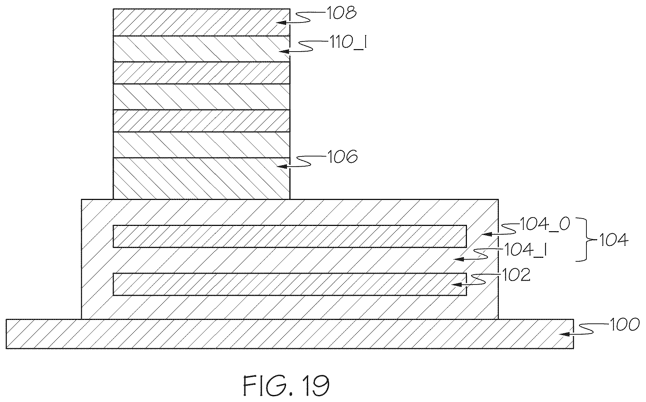

FIG. 19 is a cross-sectional view of an intermediate process, including removing the block layer.

### DETAILED DESCRIPTION OF EMBODIMENTS

Pursuant to embodiments herein, an integrated circuit device may include a stacked transistor structure including a first transistor (e.g., a lower transistor) and a second transistor (e.g., an upper transistor) vertically stacked on a substrate. The first transistor may comprise first channel layers (e.g., lower channel layers) that are spaced apart from each other in a vertical direction that is perpendicular to an upper surface of the substrate. The first transistor may further comprise a first work function layer (e.g., a lower work function layer) on the first channel layers. The first transistor may further comprise first gate insulators (e.g., lower gate insulators) between the first work function layer and the first channel layers, and a first gate electrode (e.g., a lower gate electrode) on the first work function layer. The second transistor may comprise second channel layers (e.g., upper channel layers) that are spaced apart from each other in the vertical direction. The second transistor may further comprise a second work function layer (e.g., an upper work function layer) on the second channel layers. The second transistor may further comprise second gate insulators (e.g., upper gate insulators) between the second work function layer and the second channel layers, and a second gate electrode (e.g., an upper gate electrode) on the second work function layer. In some embodiments, cach of the first channel layers and each of the second channel layers may be a nanosheet or a nanowire. The integrated circuit device may further comprise an insulator (also referred to as an inter-gate insulator or a middle dielectric isolation) between the first transistor (e.g., the first channel layers) and the second transistor (e.g., the second channel layers) in the vertical direction. The first work function layer may comprise a first inner work function layer and a first outer work function layer. The first inner work function layer may be between (adjacent) ones of the first channel layers in the vertical direction. The first outer work function layer may extend around the first channel layers and the first inner work function layer. The first outer work function layer may be between the insulator and the uppermost one of the first channel layers in the vertical direction. The first outer work function layer may be between the substrate and the lowermost one of the first channel layers in the vertical direction. The second work function layer may comprise a second inner work function layer and a second outer work function layer. The second inner work function layer may be between (adjacent) ones of the second channel layers in the vertical direction. The second outer work function layer may extend around the first channel layers, the first work function layer, the second channel layers, the second inner work function layer, and the insulator. The first channel layers may be spaced apart from the second work function layer. For example, the first channel layers may be spaced apart from the second work function layer by the first work function layer. In some embodiments, the second work function layer may have an interface between the second inner work function layer and the second outer work function layer. In some embodiments, the first work function layer may not have an interface between the first inner work function layer and the first outer work function layer. For example, the first work function layer may be a single monolithic structure. In some embodiments, the first inner work function layer and the first outer work function layer may be formed simultaneously by the same process or the same series of processes. In some embodiments, the second inner work function layer and the second outer work function layer may be formed by different processes or different series of processes.

Example embodiments will be described in greater detail with reference to the attached figures.

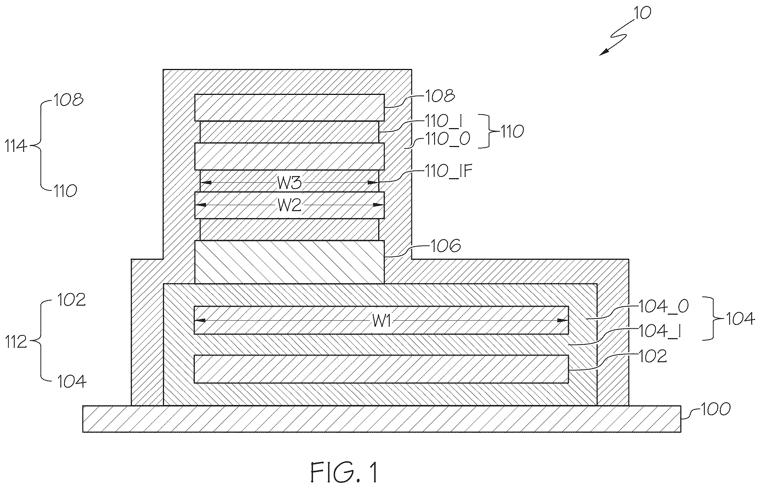

FIG. 1 is a cross-sectional view of an integrated circuit device 10 according to some embodiments. Referring to FIG. 1, the integrated circuit device 10 may include a first transistor 112 (e.g., a lower transistor 112) and a second transistor 114 (e.g., an upper transistor 114) formed on a substrate 100. The first transistor 112 may be between the substrate 100 and the second transistor 114 (in a vertical direction that is perpendicular to an upper surface and/or a lower surface of the substrate 100). In some embodiments, the center (or a central portion) of the first transistor 112 and the center (or a central portion) of the second transistor 114 may be misaligned with each other or offset (in a horizontal direction that is parallel with the upper surface and/or the lower surface of the substrate 100). The first transistor 112 and the second transistor 114 may have different conductivity types or the same conductivity type. In some embodiments, the first transistor 112 may be an N-type transistor including an N-type source/drain region (not illustrated), and the second transistor 114 may be a P-type transistor including a P-type source/drain region (not illustrated). However, the inventive concepts of the types of the first transistor 112 and the second transistor 114 are not limited to the embodiments described above. For example, the first transistor 112 may be a P-type transistor including a P-type source/drain region (not illustrated), and the second transistor 114 may be an N-type transistor including an N-type source/drain region (not illustrated).

The substrate 100 may include semiconductor material(s), for example, Si, Ge, SiGe, GaP, GaAs, SiC, SiGeC and/or InP and/or may include insulating material(s), for example, silicon oxide, silicon oxynitride, silicon nitride, silicon carbonitride and/or a low-k material. In some embodiments, the substrate 100 may be a bulk substrate (e.g., a silicon wafer), a semiconductor on insulator (SOI) substrate or an insulating layer (e.g., a monolithic insulating layer). The low-k material may have a lower dielectric constant than that of silicon oxide (e.g., SiO). The low-k material may include, for example, fluorine-doped silicon oxide, organosilicate glass, carbon-doped oxide, porous silicon dioxide, porous organosilicate glass, spin-on organic polymeric dielectrics and/or spin-on silicon based polymeric dielectric.

The first transistor 112 may comprise first channel layers 102 (e.g., lower channel layers 102) and a first work function layer 104 (e.g., a lower work function layer 104) on the first channel layers 102. Although not illustrated in FIG. 1, the first transistor 112 may further comprise first gate insulators (e.g., lower gate insulators) on the first channel layers 102, and a first gate electrode (e.g., a lower gate electrode) on the first work function layer 104. For example, the first gate insulators may be between the first channel layers 102 and the first work function layer 104. The first gate insulators, the first work function layer 104, and the first gate electrode may be collectively referred to as a first gate structure (e.g., a lower gate structure).

The first channel layers 102 may be spaced apart from each other in the vertical direction. In some embodiments, the first channel layers 102 may be spaced apart from each other at equal or substantially equal distance in the vertical direction. In some embodiments, each of the first channel layers 102 may have an equal or a substantially equal width in the horizontal direction. For example, each of the first channel layers 102 may have a first width W1 in the horizontal direction. Herein, "substantially" may mean no greater than a 10% deviation. For example, when element X has a width of 10nm and a width of element Y is substantially equal to that of element X, the width of element Y may not be less than 9nm or greater than 11nm.

Although not illustrated in FIG. 1, the first gate insulators may extend around (e.g., at least partially surround) the first channel layers 102, respectively. The first work function layer 104 may extend around (e.g., at least partially surround) the first gate insulators (and the first channel layers 102). The first gate electrode may extend around (e.g., at least partially surround) the first work function layer 104.

In some embodiments, the first channel layers 102 may include semiconductor material(s), for example, Si, Ge, SiGe, GaP, GaAs, SiC, SiGeC and/or InP. In some embodiments, the first gate insulators may include insulator(s), for example, silicon oxide, silicon oxynitride, silicon nitride, silicon carbonitride and/or a low-k material that has a lower dielectric constant than that of silicon oxide. In some embodiments, the first work function layer 104 may include, for example, a TiN layer, a TaN layer, a TiAl layer, a TiC layer, a TiAlC layer, a TiAlN layer and/or a WN layer. In some embodiments, the first gate electrode may include, for example, tungsten (W), aluminum (Al) and/or copper (Cu). However, the materials in the first channel layers 102, the first gate insulators, the first work function layer 104, and the first gate electrode are not limited to the embodiments described above. In some embodiments, the first gate insulators and the first gate electrode may be omitted.

The first work function layer 104 may comprise a first inner work function layer 104_I and a first outer work function layer 104_0. The first inner work function layer 104_I may be between adjacent ones of the first channel layers 102 in the vertical direction. The first inner work function layer 104_I may be between the lowermost one of the first channel layers 102 and the substrate 100 in the vertical direction. For example, the first inner work function layer 104_I may be on a lower surface of the lowermost one of the first channel layers 102 and the upper surface of the substrate 100. The first outer work function layer 104_O may be between the uppermost one of the first channel layers 102 and the insulator 106 (which will be described in detail later) in the vertical direction. For example, the first outer work function layer 104_O may be on an upper surface of the uppermost one of the first channel layers 102 and a lower surface of the insulator 106. The first outer work function layer 104_O may be on side surfaces of the first channel layers 102 and side surfaces of the first inner work function layer 104_I. In some embodiments, the first outer work function layer 104_O may extend around (e.g., at least partially surround) the first inner work function layer 104_I and the first channel layers 102.

In some embodiments, the first inner work function layer 104_I and the first outer work function layer 104_O may be integrally formed (in a unitary structure or a monolithic structure) to constitute the first work function layer 104. For example, the first work function layer 104 may be a single monolithic structure. The first work function layer 104 may not have an interface between the first inner work function layer 104_I and the first outer work function layer 104_O. The first work function layer 104 may be in contact with the first channel layers 102 and the insulator 106.

The second transistor 114 may comprise second channel layers 108 (e.g., upper channel layers 108) and a second work function layer 110 (e.g., an upper work function layer 110) on the second channel layers 108. Although not illustrated in FIG. 1, the second transistor 114 may further comprise second gate insulators (e.g., upper gate insulators) on the second channel layers 108, and a second gate electrode (e.g., an upper gate electrode) on the second work function layer 110. For example, the second gate insulators may be between the second channel layers 108 and the second work function layer 110. The second gate insulators, the second work function layer 110, and the second gate electrode may be collectively referred to as a second gate structure (e.g., an upper gate structure).

The second channel layers 108 may be spaced apart from each other in the vertical direction. In some embodiments, the second channel layers 108 may be spaced apart from each other at equal or substantially equal distance in the vertical direction. In some embodiments, each of the second channel layers 108 may have an equal or a substantially equal width in the horizontal direction. For example, each of the second channel layers 108 may have a second width W2 in the horizontal direction. In some embodiments the first width W1 of the first channel layers 102 may be greater than the second width W2 of the second channel layers 108.

Although not illustrated in FIG. 1, the second gate insulators may extend around (e.g., at least partially surround) the second channel layers 108, respectively. The second work function layer 110 may extend around (e.g., at least partially surround) the second gate insulators. The second gate electrode may extend around (e.g., at least partially surround) the second work function layer 110.

In some embodiments, the second channel layers 108 may include semiconductor material(s), for example, Si, Ge, SiGe, GaP, GaAs, SiC, SiGeC and/or InP. In some embodiments, the second gate insulators may include insulator(s), for example, silicon oxide, silicon oxynitride, silicon nitride, silicon carbonitride and/or a low-k material that has a lower dielectric constant than that of silicon oxide. In some embodiments, the second work function layer 110 may include, for example, a TiN layer, a TaN layer, a TiAl layer, a TiC layer, a TiAlC layer, a TiAlN layer and/or a WN layer. In some embodiments, the second gate electrode may include, for example, tungsten (W), aluminum (Al) and/or copper (Cu). However, the materials in the second channel layers 108, the second gate insulators, the second work function layer 110, and the second gate electrode are not limited to the embodiments described above. In some embodiments, the second gate insulators and the second gate electrode may be omitted.

The second work function layer 110 may comprise a second inner work function layer 110_I and a second outer work function layer 110_O. The second inner work function layer 110_I may be between adjacent ones of the second channel layers 108 in the vertical direction. The second inner work function layer 110_I may be between the lowermost one of the second channel layers 108 and the insulator 106 in the vertical direction. For example, the second inner work function layer 110_I may be on a lower surface of the lowermost one of the second channel layers 108 and an upper surface of the insulator 106. The second outer work function layer 110_O may be on an upper surface of the uppermost one of the second channel layers 108. The second outer work function layer 110_O may be on side surfaces of the second channel layers 108 and side surfaces of the second inner work function layer 110_I. In some embodiments, the second outer work function layer 110_O may be on (may be in contact with) the first outer work function layer 104_O and (the upper surface of) the substrate 100. In some embodiments, the second outer work function layer 110_O may extend around (e.g., at least partially surround) the second inner work function layer 110_I and the second channel layers 108. In some embodiments, the second outer work function layer 110_O may extend around (e.g., at least partially surround) the insulator 106, the first work function layer 104, and the first channel layers 102. For example, the second outer work function layer 110_O may be in contact with the second inner work function layer 1 10_I, the second channel layers 108, the insulator 106, the first outer work function layer 104_O, and/or the substrate 100. In some embodiments, the second outer work function layer 110_O may extend around (e.g., at least partially surround) the first transistor 112 and the second transistor 114. In some embodiments, the second work function layer 110 may be spaced apart from the first channel layers 102. For example, the second work function layer 110 may be spaced apart from the first channel layers 102 by the first work function layer 104.

The insulator 106 (also referred to as an inter-gate insulator 106 or a middle dielectric isolation 106) may be between the first transistor 112 and the second transistor 114 in the vertical direction. For example, the insulator 106 may be between the first channel layers 102 and the second channel layers 108 in the vertical direction. In some embodiments, the insulator 106 may be on the first work function layer 104 (e.g., the first outer work function layer 104_O). For example, an upper surface of the first work function layer 104 (e.g., an upper surface of the first outer work function layer 104_O) may be on (e.g., may be in contact with) a lower surface of the insulator 106. In some embodiments, the insulator 106 may be on the second inner work function layer 110_I. For example, the lower surface (e.g., the lowermost surface) of the second inner work function layer 110_I may be on (e.g., may be in contact with) an upper surface of the insulator 106.

In some embodiments, the second work function layer 110 may include an interface 110_IF between the second inner work function layer 110_I and the second outer work function layer 110_O. For example, the second inner work function layer 110_I may be bounded by the second outer work function layer 110_O with the interface 110_IF therebetween. In some embodiments, the second inner work function layer 110_I may have a third width W3 in the horizontal direction. The third width W3 may be less than the second width W2 of the second channel layers 108. For example, the interface 110_IF of the second work function layer 110 may overlap the second channel layers 108 in the vertical direction. For example, a portion of the second outer work function layer 110_O may protrude in the horizontal direction toward the second inner work function layer 110_I between adjacent ones of the second channel layers 108 in the vertical direction and/or between the lowermost one of the second channel layers 108 and the insulator 106 in the vertical direction.

The insulator 106 may be in contact with the first work function layer 104 and the second work function layer 110. For example, the insulator 106 may be in contact with the first outer work function layer 104_O, the second inner work function layer 110_I, and the second outer work function layer 110_O. The insulator 106 may include insulator(s), for example, silicon nitride (e.g., SiN). However, the material of the insulator 106 is not limited thereto.

In some embodiments, the first inner work function layer 104_I and the first outer work function layer 104_O may include the same material (e.g., a first material). In some embodiments, the second inner work function layer 110_I and the second outer work function layer 110_O may include the same material (e.g., a second material). In some embodiments, the first material of the first work function layer 104 may be different from the second material of the second work function layer 110. In some embodiments, the second inner work function layer 110_I and the second outer work function layer 110_O may include different materials. For example, the second inner work function layer 110_I may include the second material, and the second outer work function layer 110_O may include a third material that is different from the first material of the first work function layer 104 and the second material of the second inner work function layer 110_I.

In some embodiments, cach of the first channel layers 102 and the second channel layers 108 may be a nanosheet (that may have a thickness in a range of from 1 nm to 100 nm in the vertical direction) or may be a nanowire (that may have a circular cross-section with a diameter in a range of from 1 nm to 100 nm).

Although FIG. 1 illustrates that the first transistor 112 includes two first channel layers 102, in some embodiments, the first transistor 112 may include one or more than two first channel layers 102. Although FIG. 1 illustrates that the second transistor 114 includes three second channel layers 108, in some embodiments, the second transistor 114 may include one, two or more than three second channel layers 108.

Although not shown in FIGS. 1, the integrated circuit device 10 may also include a middle-of-line (MOL) structure and a back-end-of-line (BEOL) structure. Each of the MOL and BEOL structures may include interlayer insulating layer(s) in which conductive wire(s) (e.g., metal wire(s)) and conductive via plug(s) (e.g., metal via plug(s)) are provided. Various elements of the first transistor 112 and the second transistor 114 may be (electrically) connected to one of the conductive wires of the MOL and BEOL structures.

Further, in some embodiments, a backside power distribution network structure (BSPDNS) may be provided below or within the substrate 100. In some embodiments, some elements of the BSPDNS may be provided in the substrate 100. The BSPDNS may include backside insulating layer(s) in which conductive backside wire(s) (e.g., metal power rail(s)) and conductive backside contact(s) (e.g., backside metal contact(s)) are provided. Various elements of the first transistor 112 and the second transistor 114 may be (electrically) connected to one of the conductive backside wires.

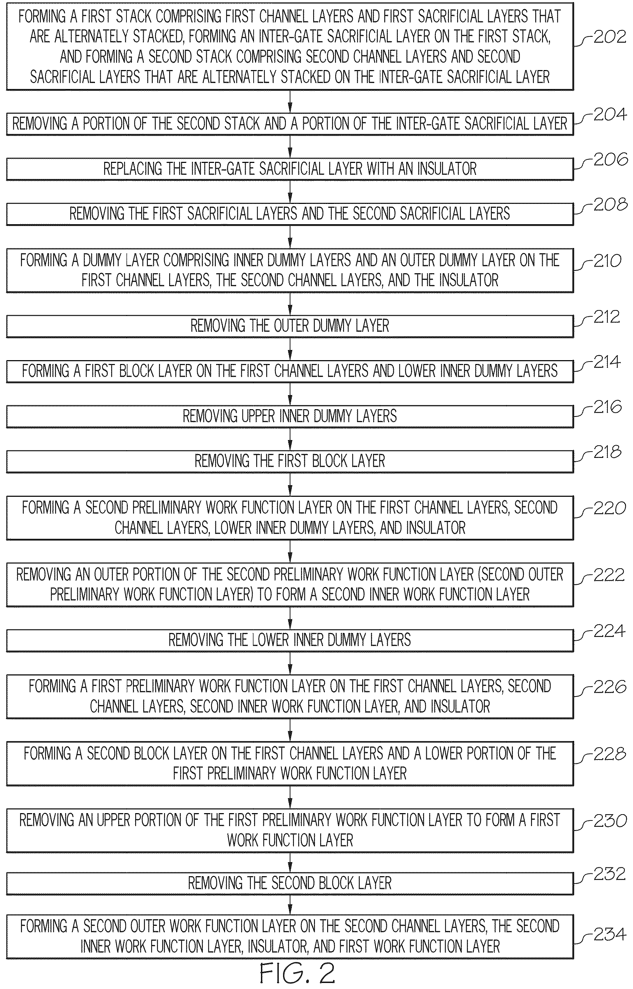

FIG. 2 is a flowchart of methods of forming an integrated circuit device according to some embodiments. For example, FIG. 2 is a flowchart of methods of forming the integrated circuit device 10 according to some embodiments illustrated in FIG. 1.

FIGS. 3 through 19 are cross-sectional views illustrating methods of forming an integrated circuit device according to some embodiments. For example, FIGS. 3 through 19 are cross-sectional views illustrating methods of forming the integrated circuit device 10 according to some embodiments illustrated in FIG. 1.

Referring to FIGS. 1, 2, and 3, the method may include forming a first stack 318 (e.g., a lower stack 318) on the substrate 100 (Block 202). The first stack 318 may comprise the first channel layers 102 and first sacrificial layers 312 (e.g., lower sacrificial layers 312). In some embodiments, the first channel layers 102 and the first sacrificial layers 312 may be alternately stacked in the vertical direction. In some embodiments, the first sacrificial layers 312 may include a material having an etch selectivity with respect to the first channel layers 102. For example, the first sacrificial layers 312 may include SiGe.

Referring to FIGS. 1, 2, and 3, an inter-gate sacrificial layer 316 (also referred to as a middle sacrificial layer 316) may be formed on the first stack 318 (Block 202). The first stack 318 may be between the inter-gate sacrificial layer 316 and the substrate 100 in the vertical direction. In some embodiments, the inter-gate sacrificial layer 316 may include SiGe.

Referring to FIGS. 1, 2, and 3, a second stack 320 (e.g., an upper stack 320) may be formed on the inter-gate sacrificial layer 316 (Block 202). The inter-gate sacrificial layer 316 may be between the first stack 318 and the second stack 320 in the vertical direction. The second stack 320 may include the second channel layers 108 and second sacrificial layers 314 (e.g., upper sacrificial layers 314). In some embodiments, the second channel layers 108 and the second sacrificial layers 314 may be alternately stacked in the vertical direction. In some embodiments, the second sacrificial layers 314 may include a material having an etch selectivity with respect to the second channel layers 108. For example, the second sacrificial layers 314 may include SiGe.

In some embodiments, the inter-gate sacrificial layer 316 may include a material having an etch selectivity with respect to the first channel layers 102, the first sacrificial layers 312, the second channel layers 108, and the second sacrificial layers 314. For example, the inter-gate sacrificial layer 316 may include SiGe with a different Ge concentration from SiGe of the first sacrificial layers 312 and the second sacrificial layers 314. However, the materials of the first sacrificial layers 312, the second sacrificial layers 314, and the inter-gate sacrificial layer 316 are not limited to the embodiments described above.

Referring to FIGS. 1, 2, and 4, a portion of the second stack 320 and a portion of the inter-gate sacrificial layer 316 may be removed (e.g., etched) to expose a portion of (a portion of an upper surface of) the first stack 318 (Block 204).

Referring to FIGS. 1, 2, 5, and 6, the inter-gate sacrificial layer 316 may be removed, and the insulator 106 may be formed in the space from which the inter-gate sacrificial layer 316 has been removed. In some embodiments, the inter-gate sacrificial layer 316 may be replaced with the insulator 106. (Block 206). For example, as the inter-gate sacrificial layer 316 may have an etch selectivity with respect to the first channel layers 102, the first sacrificial layers 312, the second channel layers 108, and the second sacrificial layers 314, the inter-gate sacrificial layer 316 may be selectively etched while not etching the first stack 318 and the second stack 320. Then, the insulator 106 may be formed in the space from which the inter-gate sacrificial layer 316 has been etched. In some embodiments, the shape of the insulator 106 may be the same or substantially the same as the shape of the inter-gate sacrificial layer 316 that has been removed.

Referring to FIGS. 1, 2, and 7, the first sacrificial layers 312 and the second sacrificial layers 314 may be removed (Block 208).

Referring to FIGS. 1, 2, and 8, a dummy layer 822 may be formed on (e.g., may be formed to be in contact with) the first channel layers 102, the second channel layers 108, the insulator 106, and the substrate 100 (Block 210). The dummy layer 822 may include aluminum oxide (e.g., AlO), but the material in the dummy layer 822 is not limited thereto. In some embodiments, the dummy layer 822 may extend around (at least partially surround) each of the first channel layers 102, each of the second channel layers 108, and the insulator 106. The dummy layer 822 may comprise an inner dummy layer 822_I and an outer dummy layer 822_O. In some embodiments, the inner dummy layer 822_I may be between adjacent ones of the first channel layers 102 in the vertical direction, between adjacent ones of the second channel layers 108 in the vertical direction, between the uppermost one of the first channel layers 102 and the insulator 106 in the vertical direction, between the lowermost one of the second channel layers 108 and the insulator 106 in the vertical direction, and between the lowermost one of the first channel layers 102 and the substrate 100 in the vertical direction. The outer dummy layer 822_O may extend around the inner dummy layer 822_I, the first channel layers 102, the second channel layers 108, and the insulator 106.

Referring to FIGS. 1, 2, and 9, the outer dummy layer 822_O may be removed (Block 212). In some embodiments, the substrate 100, the first channel layers 102, the insulator 106, and the second channel layers 108 may be alternately stacked with the inner dummy layers 822_I in the vertical direction. Herein, the inner dummy layers 822_I that are between the insulator 106 and the substrate 100 in the vertical direction may be referred to as lower inner dummy layers 822_I. On the other hand, the inner dummy layers 822_I that are between the insulator 106 and the uppermost one of the second channel layers 108 in the vertical direction may be referred to as upper inner dummy layers 822_I. The dummy layer 822 (e.g., the outer dummy layer 822_O) may be removed by, for example, diluted ammonia mixture (ADM) and/or standard clean 1 (SC1).

Referring to FIGS. 1, 2, and 10, a first block layer 1024 may be formed on (e.g., may be formed to be in contact with) the first channel layers 102 and the lower inner dummy layers 822_I (Block 214). For example, the first block layer 1024 may overlap the first channel layers 102 and the lower inner dummy layers 822_I in the horizontal direction and/or the vertical direction. The first block layer 1024 may be formed on the substrate 100 and extend around (e.g., at least partially surround) the first channel layers 102 and the lower inner dummy layers 822_I. In some embodiments, the first block layer 1024 may be on the insulator 106. For example, the first block layer 1024 may overlap the insulator 106 in the horizontal direction. The first block layer 1024 may extend around (e.g., at least partially surround) the insulator 106. In some embodiments, a portion (e.g., an upper portion) of the insulator 106 may be exposed from the first block layer 1024. The upper inner dummy layers 822_I and the second channel layers 108 may be exposed from the first block layer 1024. In some embodiments, a preliminary block layer may be formed on the substrate 100, the first channel layers 102, the second channel layers 108, and the inner dummy layers 822_I and then may be partially removed through a lithography process, including, for example, bottom anti-reflective coating (BARC) forming, photoresist (PR) coating, exposing, and developing, to expose the second channel layers 108 and the upper inner dummy layers 822_I and to form the first block layer 1024. The first block layer 1024 may include an organic planarization layer (OPL), but is not limited thereto.

Referring to FIGS. 1, 2, and 11 the upper inner dummy layers 822_I may be removed (Block 216). For example, the upper inner dummy layers 822_I may be removed by an ashing process and/or a strip process. The lower inner dummy layers 822_I may remain as the first block layer 1024 protects the lower inner dummy layers 822_I.

Referring to FIGS. 1, 2, and 12, the first block layer 1024 may be removed (Block 218).

Referring to FIGS. 1, 2, and 13, the second preliminary work function layer 1310 may be formed on the first channel layers 102, the insulator 106, the second channel layers 108, the lower inner dummy layers 822_I, and the substrate 100 (Block 220). In some embodiments, the second preliminary work function layer 1310 may include, for example, a TiN layer, a TaN layer, a TiAl layer, a TiC layer, a TiAlC layer, a TiAlN layer and/or a WN layer. The second preliminary work function layer 1310 may comprise a second inner preliminary work function layer 1310_I and a second outer preliminary work function layer 1310_O. The second inner preliminary work function layer 1310_I may be between adjacent ones of the second channel layers 108 in the vertical direction and between the lowermost one of the second channel layers 108 and the insulator 106 in the vertical direction. The second outer preliminary work function layer 1310_O may be on (e.g., may be in contact with) the first channel layers 102, the lower inner dummy layers 822_I, the insulator 106, the second channel layers 108, the second inner preliminary work function layer 1310_I, and the substrate 100. For example, the second outer preliminary work function layer 1310_O may extend around (e.g., at least partially surround) the first channel layers 102, the lower inner dummy layers 822_I, the insulator 106, the second channel layers 108, and the second inner preliminary work function layer 1310_I.

Referring to FIGS. 1, 2, and 14, the second outer preliminary work function layer 1310_O may be removed (Block 222). The second inner preliminary work function layer 1310_I may remain as the second inner work function layer 110_I.

Referring to FIGS. 1, 2, and 15, the lower inner dummy layers 822_I may be removed (Block 224).

Referring to FIGS. 1, 2, and 16, the first preliminary work function layer 1604 may be formed on (e.g., may be formed to be in contact with) the first channel layers 102, the insulator 106, the second channel layers 108, the second inner work function layer 110_I, and the substrate 100 (Block 226). The first preliminary work function layer 1604 may include, for example, a TiN layer, a TaN layer, a TiAl layer, a TiC layer, a TiAlC layer, a TiAlN layer and/or a WN layer. In some embodiments, the first preliminary work function layer 1604 may include a material that is different from a material in (of) the second preliminary work function layer 1310 (the second inner work function layer 110_I). For example, the first preliminary work function layer 1604 may have physical, chemical, and/or electrical features different from those of the second preliminary work function layer 1310. The first preliminary work function layer 1604 may comprise a first inner preliminary work function layer 1604_I and a first outer preliminary work function layer 1604_O. The first inner preliminary work function layer 1604_I may be between adjacent ones of the first channel layers 102 in the vertical direction. The first outer preliminary work function layer 1604_O may be between the lowermost one of the first channel layers 102 and the substrate 100 in the vertical direction and between the uppermost one of the first channel layers 102 and the insulator 106 in the vertical direction. The first outer preliminary work function layer 1604_O may be on (e.g., may be in contact with) the first channel layers 102, the first inner preliminary work function layer 1604_I, the insulator 106, the second channel layers 108, the second inner work function layer 110_I, and the substrate 100. For example, the first outer preliminary work function layer 1604_O may extend around (e.g., at least partially surround) the first channel layers 102, the first inner preliminary work function layer 1604_I, the insulator 106, the second channel layers 108, and the second inner work function layer 110_I.

Referring to FIGS. 1, 2, and 17, a second block layer 1726 may be formed on the first channel layers 102 and (a lower portion of) the first preliminary work function layer 1604 (Block 228). For example, the second block layer 1726 may overlap the first channel layers 102, the first inner preliminary work function layer 1604_I, and (a lower portion of) the first outer preliminary work function layer 1604_O in the horizontal direction and/or the vertical direction. The second block layer 1726 may be formed on the substrate 100 and extend around (e.g., at least partially surround) the first channel layers 102, the first inner preliminary work function layer 1604_I, and (a lower portion of) the first outer preliminary work function layer 1604_O. In some embodiments, the second block layer 1726 may be on the insulator 106. For example, the second block layer 1726 may overlap the insulator 106 in the horizontal direction. The second block layer 1726 may extend around (e.g., at least partially surround) the insulator 106. In some embodiments, a portion (e.g., an upper portion) of the insulator 106 may be exposed from the second block layer 1726. The second inner work function layer 110_I and the second channel layers 108 may be exposed from the second block layer 1726. In some embodiments, a preliminary block layer may be formed on the substrate 100, the first channel layers 102, the insulator 106, the second channel layers 108, the second inner work function layer 110_I, and the first preliminary work function layer 1604 and then may be partially removed through a lithography process, including, for example, BARC forming, PR coating, exposing, and developing, to expose the second inner work function layer 110_I, the second channel layers 108, and an upper portion of the first preliminary work function layer 1604 and to form the second block layer 1726. The second block layer 1726 may be an organic planarization layer (OPL), but is not limited thereto.

Referring to FIGS. 1, 2, and 18, an upper portion of the first preliminary work function layer 1604 may be removed (e.g., wet etched) (Block 230). For example, an upper portion of the first outer preliminary work function layer 1604_O may be removed. A lower portion of the first preliminary work function layer 1604 may remain to form the first work function layer 104 that comprises the first inner work function layer 104_I and the first outer work function layer 104_O. In some embodiments, the upper portion of the first preliminary work function layer 1604 may be removed to expose the second channel layers 108, the second inner work function layer 110_I, side surfaces of the insulator 106, and portions of the upper surface of the first outer work function layer 104_O.

Referring to FIGS. 1, 2, and 19, the second block layer 1726 may be removed (Block 232).

Referring to FIGS. 1 and 2, the second outer work function layer 110_O may be formed on (e.g., may be formed to be in contact with) the second channel layers 108, the second inner work function layer 110_I, the insulator 106, the first work function layer 104 (e.g., the first outer work function layer 104_O), and the substrate 100 (Block 234). In some embodiments, the second inner work function layer 110_I may be recessed in the horizontal direction during the manufacturing processes. For example, side surfaces of the second inner work function layer 110_I may overlap the second channel layers 108 in the vertical direction. The second inner work function layer 110_I may be recessed during the processes described with reference to FIGS. 14 to 19. However, the processes that may cause the recession of the second inner work function layer 110_I are not limited to the embodiments described above. The side surfaces of the second inner work function layer 110_I may become interfaces 110_IF between the second inner work function layer 110_I and the second outer work function layer 110_O after the formation of the second outer work function layer 110_O on the second inner work function layer 110_I. In some embodiments, the second outer work function layer 110_O may include a TiN layer, a TaN layer, a TiAl layer, a TiC layer, a TiAlC layer, a TiAlN layer and/or a WN layer, but is not limited thereto. In some embodiments, the second inner work function layer 110_I and the second outer work function layer 110_O may include the same material. However, the embodiments of the inventive concepts are not limited thereto. In some embodiments, the second inner work function layer 110_I may include a material that is different from a material in (of) the second outer work function layer 110_O.

Referring to FIGS. 1, 18, and 19, the removing (e.g., etching) target of the upper portion of the first preliminary work function layer 1604 (e.g., the upper portion of the first outer preliminary work function layer 1604_O) may be the same or substantially the same as the thickness of the first preliminary work function layer 1604. In some embodiments, the removing target of the upper portion of the first preliminary work function layer 1604 may include the thickness of the first preliminary work function layer 1604 and an over (excessive) etching margin. Unlike conventional process, the removing (e.g., etching) target of the upper portion of the first preliminary work function layer 1604 may be less than the width of the second channel layers 108 in the horizontal direction. The process of removing the upper portion of the first preliminary work function layer 1604 may not form (may reduce) a path (e.g., ,an opening or a trench) extending through (or extending into) the first channel layers 102 and the first work function layer 104 by an excessive etching, and the second work function layer 110 may be spaced apart from the first channel layers 102. For example, the second work function layer 110 may be spaced apart from the first channel layers 102 by the first work function layer 104. As a result, the integrated circuit device 10 may reduce the potential wet etch damage (e.g., etch damage on the gate insulator). Also, the boundary shift between the first transistor 112 and the second transistor 114 (e.g., the boundary shift between a P-type transistor and an N-type transistor) may be reduced. As a result, the process margin of the integrated circuit device 10 may be improved (e.g., reducing or preventing the loss of the first work function layer 104), and the performance of multi-threshold voltage (Vth) structure (e.g., Vth of the first transistor 112 and Vth of the second transistor 114) of the integrated circuit device 10 may be improved. In addition, as the first work function layer 104 does not need to be formed between adjacent ones of the second channel layers 108 and removed therefrom, potential unstrap defects between the second channel layer 108 may be reduced (e.g., prevented).

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present inventive concepts to those skilled in the art. In the drawings, the sizes and relative sizes of layers and regions may be exaggerated for clarity. Like reference numbers may refer to like elements throughout unless clearly stated otherwise.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present inventive concepts.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

As used herein, "an element A overlapping an element B in a direction X" (or similar language) means that there is at least one line that extends in the direction X and intersects both the elements A and B.

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

As used herein, "a lower surface" refers to a surface facing a substrate (e.g., the substrate 100 in FIG. 1), and "an upper surface" refers to a surface opposite the lower surface. Further, as used herein, "a lower portion" refers to a portion that is closer than "an upper portion" to the substrate.

Many different embodiments have been disclosed herein, in connection with the above description and the drawings. It will be understood that it would be unduly repetitious and obfuscating to literally describe and illustrate every combination and sub-combination of these embodiments. Accordingly, the present specification, including the drawings, shall be construed to constitute a complete written description of all combinations and sub-combinations of the embodiments described herein, and of the manner and process of making and using them, and shall support claims to any such combination or sub-combination.

## Claims

1. An integrated circuit device comprising:
a first transistor on a substrate; and
a second transistor on the first transistor, wherein the first transistor is between the substrate and the second transistor in a vertical direction that is perpendicular to an upper surface of the substrate,
wherein the first transistor comprises:
first channel layers that are spaced apart from each other in the vertical direction; and
a first work function layer on the first channel layers,
wherein the second transistor comprises:
second channel layers that are spaced apart from each other in the vertical direction; and
a second work function layer on the second channel layers, and
wherein the second work function layer is spaced apart from the first channel layers.

2. The integrated circuit device of Claim 1, wherein the first work function layer is between the first channel layers and the second work function layer.

3. The integrated circuit device of Claim 2, wherein the second work function layer includes a second inner work function layer and a second outer work function layer,
wherein the second inner work function layer is between adjacent ones of the second channel layers,
wherein the second outer work function layer extends around the second channel layers and the second inner work function layer, and
wherein the second work function layer has an interface between the second inner work function layer and the second outer work function layer.

4. The integrated circuit device of Claim 3, wherein the first work function layer includes a first inner work function layer and a first outer work function layer,
wherein the first inner work function layer is between adjacent ones of the first channel layers,
wherein the first outer work function layer extends around the first channel layers and the first inner work function layer, and
wherein the first work function layer is free of an interface between the first inner work function layer and the first outer work function layer.

5. The integrated circuit device of Claim 4, wherein the first inner work function layer and the first outer work function layer are configured to form an integrated structure.

6. The integrated circuit device of Claim 4 or 5, wherein the interface of the second work function layer overlaps the second channel layers in the vertical direction.

7. The integrated circuit device of Claim 6, wherein a width of at least one of the second channel layers in a horizontal direction that is parallel with the upper surface of the substrate is greater than a width of the second inner work function layer in the horizontal direction.

8. The integrated circuit device of any one of Claims 4 to 7, wherein the first inner work function layer and the first outer work function layer include a first material.

9. The integrated circuit device of Claim 8, wherein the second inner work function layer and the second outer work function layer include a second material that is different from the first material.

10. The integrated circuit device of Claim 8, wherein the second inner work function layer includes a second material,
wherein the second outer work function layer includes a third material, and
wherein the second material is different from the first material and the third material.

11. A method of forming an integrated circuit device, the method comprising:
forming a first stack that comprises first channel layers on a substrate and a second stack that comprises second channel layers on the first stack, wherein the first channel layers are spaced apart from each other in a vertical direction that is perpendicular to an upper surface of the substrate, and the second channel layers are spaced apart from each other in the vertical direction;
forming an insulator between the first stack and the second stack in the vertical direction;
forming a dummy layer that extends around the first channel layers, the second channel layers, and the insulator;
replacing an upper portion of the dummy layer with a first inner work function layer that is on the second channel layers;
replacing a lower portion of the dummy layer with a second work function layer that is on the first channel layers; and
forming a first outer work function layer on the first inner work function layer, the insulator, and the second work function layer,
wherein the first outer work function layer is spaced apart from the first channel layers by the second work function layer.

12. The method of Claim 11, wherein the first outer work function layer is in contact with the first inner work function layer.

13. The method of Claim 12, wherein the integrated circuit device includes an interface between the first outer work function layer and the first inner work function layer.

14. The method of Claim 13, wherein the first outer work function layer and the first inner work function layer include a first material, and
wherein the second work function layer includes a second material that is different from the first material.
